## Europäisches Patentamt
## European Patent Office
## Office européen des brevets

(11) Publication number: **0 050 919**
**B1**

(12) **EUROPEAN PATENT SPECIFICATION**

(45) Date of publication of patent specification: **10.02.88**

(51) Int. Cl.⁴: **G 06 F 12/12**

(21) Application number: **81304386.6**

(22) Date of filing: **23.09.81**

(54) **LRU resolving network apparatus.**

(30) Priority: **27.10.80 US 200876**

(43) Date of publication of application:
**05.05.82 Bulletin 82/18**

(45) Publication of the grant of the patent:
**10.02.88 Bulletin 88/06**

(84) Designated Contracting States:
**DE FR GB**

(56) References cited:
**GB-A-1 161 930**
**US-A-3 958 228**
**US-A-4 115 855**
**US-A-4 168 541**

**IBM TECHNICAL DISCLOSURE BULLETIN, vol.
10, no. 10, March 1968, pages 1541-1542, New
York; US; J.S.LIPTAY: "Logical push-down list"**

(73) Proprietor: **CONTROL DATA CORPORATION**
**8100-34th Avenue South**
**Minneapolis Minnesota 55440 (US)**

(72) Inventor: **Lane, Thomas Alan**
**4048 86th Lane**
**New Brighton Minnesota 55112 (US)**
Inventor: **Webb, David Michael**
**831 Northeast 132nd Lane**
**Blaine Minnesota 55434 (US)**

(74) Representative: **Caro, William Egerton et al
J. MILLER & CO. Lincoln House 296-302 High
Holborn
London WC1V 7JH (GB)**

Courier Press, Leamington Spa, England.

## Description

This invention relates to LRU (least recently used) resolving network.

In certain types of computing systems, it is useful to know which of several, usually similar, component devices in the system has gone the longest without being used. For example, if the component devices are main memories, cache memories, or memory areas storing pages in a virtual memory computer system, when a new page not in one of the memories is requested, it is common practice to use the memory or memory area which has gone the longest without reference as the repository for the new page. This has become known as the least recently used (LRU) algorithm. Because time is quite important in resolving LRU status, dedicated hardware is frequently employed for this purpose. Typical hardware of this type is shown in Computer Storage Systems and Technology, p. 596, Richard Matick, 1977, John Wiley & Sons.

GB—A—1,161,930 discloses a least recently used resolving network of the type having a plurality of use input lines, each line having assigned to it one existing device whose use history is to be included in the resolution and carrying a use input signal pulse generated responsive to each use of the assigned device, the network comprising a plurality of use flip-flops for recording the relative use history of the devices, each flip-flop being of a type having set and reset inputs and set and reset outputs producing signals logically inverted with respect to each other and respectively associated with corresponding inputs, each of the outputs producing a logical 1 signal responsive to a use signal pulse received at its corresponding input, and the inputs of each use flip-flop being connected to the use input lines assigned to a unique combinatorial pair of devices and a plurality of multiple input AND gates, each associated with one use input line to indicate its assigned device as the least recently used device when all inputs to the AND gate are satisfied, and receiving, in operation, as inputs the others of the outputs of the use flip-flops associated with an input connected to the use input line with which the AND gate is associated. A similar network is disclosed in IBM Technical Disclosure Bulletin, Vol. 10, March 1968, pages 1541 and 1542, and in US—A—4,115,855.

With certain types of new memories, a trade-off of high speed and low cost is made versus reliability. In such a situation, if one memory fails and is not used, the other devices can be used with greater frequency and somewhat lower overall speed until the faulty memory can be replaced or repaired. Such a faulty memory should not be considered in resolving the LRU algorithm, even though it will in fact, through its deliberate non-use, become the LRU device shortly after it becomes faulty. Accordingly, it is necessary to modify or disable the conventional LRU resolving network apparatus to ignore the not-to-be-used memory or other device.

In US—A—3,958,228 is disclosed a complex arrangement for indicating a least recently used unit by logic implementation of an LRU algorithm. Included is a fault mode LRU decoder comprising a series of AND-INVERT circuits which respond to another series of AND-INVERT circuits and a series of OR circuits which respond either to the first series of AND-INVERT circuits in the fault mode, or to yet another series of AND-INVERT circuits in the normal mode, so as to provide the necessary indication.

According to the present invention, there is provided a least recently used resolving network of the type having a plurality of use input lines (20—23), each line having assigned to it one existing device (A—D) whose use history is to be included in the resolution and carrying a use input signal pulse generated responsive to each use of the assigned device, the network comprising a plurality of use flip-flops (10—15) for recording the relative use history of all said devices, each flip-flop being of the type having set and reset inputs (S, R) and set and reset outputs (S, R) producing signals logically inverted with respect to each other and respectively associated with the corresponding inputs, each of said outputs producing a logical 1 signal responsive to a use signal pulse received at its associated input, and the inputs of each use flip-flop being connected to the use input lines assigned to a unique combinatorial pair of devices (AB, AC, AD, BC, BD, CD) at least one use input disable line (50a, 51a, 52a, 53a) which, when carrying a disable signal indicates that an associated use input line (20, 21, 22, 23) and the device (A, B, C, D) assigned thereto are to be ignored in resolving the LRU status of the devices, at least one set of OR gates (60—62, 63—65, 66—68, 69—71), each set being associated with one use input line, and each OR gate in the set being connected to receive at a first input, the other of the outputs of a different use flip-flop (30a—35b) having as one input the use input line (20—23) with which the set of OR gates is associated, and to receive at a second input, the use input disable line (50a—53a) associated with the use input line (20—23) to which is assigned a device (A, B, C, D) other than the device assigned to the use input line associated with the set of OR gates, and a plurality of multiple input AND gates (100—103), each associated with one use input line to indicate its assigned device as the least recently used device when all the inputs to the AND gate are satisfied, and each receiving, in operation, as inputs the outputs of the set of OR gates associated with use input line with which the AND gate is associated, and as an additional input (50b—53b) the logical inversion of the signal on the disable line whose associated input line (20—23) is that associated with the AND gate.

Preferably, the network comprises at least one group of OR gates, each group associated with one use input line, each OR gate in a group being connected at a first input to the output corresponding to the input use line associated with that group of OR gates of a different use flip-flop having an input connected to the use input line associated with that group of OR gates, and at a second input to the use input disable line associated with the device whose use input line is associated with that group of OR gates, and a plurality of multiple input AND gates, each associated with one use input line to indicate its assigned device as the least recently used device when all inputs to the AND gate are satisfied and receiving, in operation, as inputs the outputs of a set of the OR gates and the logical inversion of the disable signal associated with the device assigned to the AND gate, each OR gate in a set being one of those whose first input is from the other output of a use flip-flop whose one output corresponds with the input from the use input line associated with the device assigned to the AND gate receiving the outputs of that set of OR gates, and whose second input is from a use disable line associated with a device other than the device assigned to the AND gate.

The network may include at least one disable flip-flop for supplying a disable signal from its set output, and for receiving at its set input a use input disable signal associated with a device, so that a pulse setting the flip-flop receiving it is indicative that the associated device is to be ignored in resolving usage of the devices.

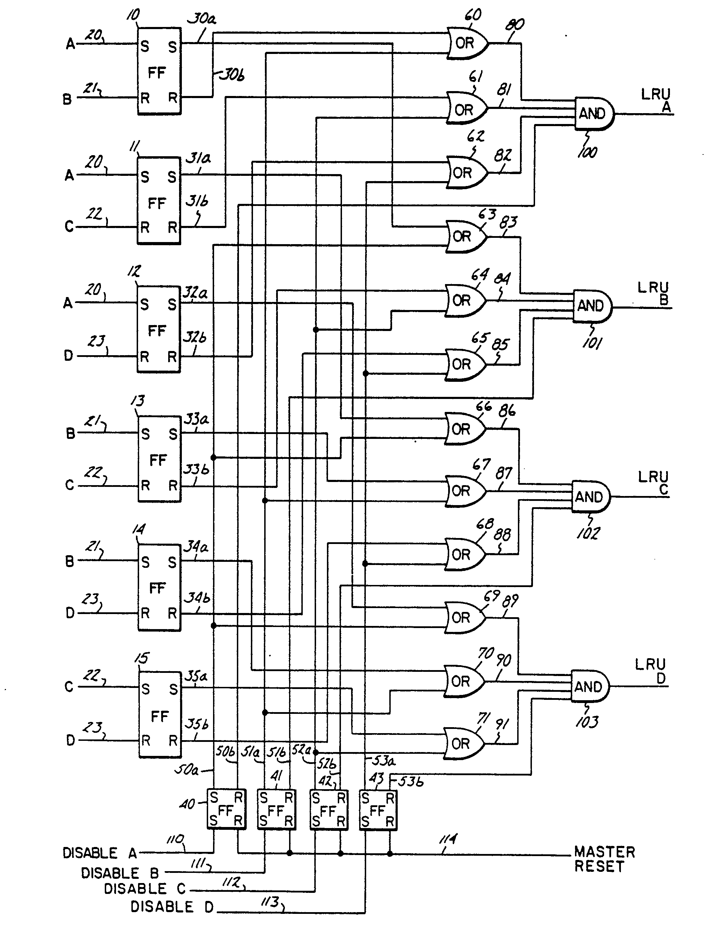

The invention is illustrated, merely by way of example in the accompanying drawing which is a schematic diagram of a least recently used resolving network according to the present invention.

The drawing shows 4 devices, A, B, C, D each of which generates a use signal pulse having a logical level of 1 each time the device is used. Only one device is in use and only one pulse generated at any given time. The devices A—D are assigned respectively to use input lines 20—23, each of which carries the use signal pulses from its respective device. The use input lines 20 to 23 are connected in unique combinatorial pairs to the set (S) and reset (R) inputs of use flip-flops 10 to 15. The use flip-flops 10 to 15 are of the conventional type which have set and reset outputs respectively associated with the set and reset inputs. They produce a logical 1 signal responsive to a logical 1 signal at the associated input and maintain the logical 1 level until a logical 1 signal is applied to the not associated input of the use flip-flop. The use flip-flops each have a respective set (or S) output lines 30a to 35a and a respective reset (or R) output lines 30b to 35b. The outputs of each use flip-flop 10 to 15 are always logically inverted with respect to each other, i.e. the output whose associated input has not last received a logical 1 signal, produces a logical 0 signal. For purposes of the present invention, the set and reset input terminals are wholly arbitrary designations to distinguish between each one of the pair of inputs of the use flip-flop.

The known prior art technique as well as the present invention is totally general as far as the number of devices to be included for least recently used (LRU) resolution. In fact, the number of use flip-flops required for a particular network is simply the combination of the number of devices whose use history is to be resolved, taken two at a time. Thus for 4 devices, 6 use flip-flops are required.

The use flip-flops 10 to 15 record the time relative usage history as between each pair of use input lines 20 to 23. A use signal pulse on any one of the use input lines 20 to 23 indicates use of the device assigned to that use input line and causes that side of each use flip-flop 10 to 15 connected to the line 20 to 23 involved, to be set. Thus, a pulse on the use input line 20 causes use flip-flops 10, 11, 12 to have their set output lines 30a, 31a and 32 to be set, that is, to produce a logical 1 signal indicating that devices B, C, and D all have earlier lastest uses than the device A. If at some later time, a use signal pulse is placed on the use input line 23, which indicates use of the device D, then the use flip-flop 12 will change so that it is reset and its reset output line 32b will be set to logical 1, indicating that the device A now has an earlier latest use than the device D. Of course, the use flip-flops 14 and 15 may well be altered as well.

A plurality of OR gates 60 to 71 provide a means of eliminating consideration of each device for which a use input disable line 50a, 51a, 52a, 53a exists and carries a disable signal. The disable signal when present simulates the condition that its associated use input line 20, 21, 22, 23 has carried a use signal pulse more recently than any use input line not associated with a use input disable line carrying a disable signal.

AND gates 100 to 103 resolve the use history recorded by the use flip-flops 10 to 15 among those use input lines not associated with a disable signal. Each AND gate 100 to 103, when producing a logical 1 signal, indicates that the device associated with it is in fact the device whose last use is earlier than any others, and is not disabled. To provide for sensing this last (not disabled) condition, logical inverse of the disable signals on the use input disable lines 50a, 51a, 52a, and 53a must be applied to the AND gates 100 to 103. Lines 50b, 51b, 52b and 53b respectively carry the logical inversions for the respective disable signals on the use input disable lines 50a, 51a, 52a, and 53a. When the logical inverse of the disable signal is applied to one input of any of the AND gates 100 to 103, that AND gate senses the signal and produces a logical 0 signal thereby allowing only those AND gates associated with undisabled devices to produce a logical 1 signal indicating LRU status.

Although not essential, disable flip-flops 40 to 43 are included to form a commercial embodiment and record the disable status of each device. Each disable flip-flop 40 to 43 is identical to flip-flops 10 to 15. Each is associated respectively with one of the devices A to D and therefore, also of course, respectively with one use input line 20 to 23. Typically, once a device is disabled it will be disabled for a relatively long period of time, and when one device is again activated, typically all devices will undergo the same maintenance or replacement procedures. Accordingly, the set terminals of the disable flip-flops 40 to 43 are individually activated by signal paths 110 to 113 respectively which indicate inactivation of the associated device with a short pulse sufficient to set the associated disable flip-flop 40 to 43. The disable flip-flops 40 to 43 can be cleared en masse by a master reset line 114. Conveniently, the S and R outputs for conventional flip-flops are the logical inverse of each other, so that disable signals for the OR gates 60 to 71 and the logical inversions thereof for input to the AND gates 100 to 103 are available.

The OR gates 60 to 71 can be conveniently organised into 4 OR gate groups, each group associated with one use input line and the device assigned to it. For example, the OR gates 60, 67, 70 form a group associated with the device B and the use signal pulse on the use input line 21. The association is on the basis that the gates in each of the groups each have one input connected to a different one of the outputs of the use flip-flops 10 to 15 associated with a single one of the use input lines 20 to 23 to which the associated device is assigned. The effect is to set the output of one OR gate to logical 1 when the device assigned to the use input line and associated with the OR gate group of which the particular OR gate is a member, has been used more recently than the other device whose use input line is connected to the use flip-flop supplying the input of the OR gate. In addition, each OR gate in a particular group is connected at its second input to the use input disable line associated with the use input line associated with the group. The effect of setting a particular disable signal to logical 1 is to cause the output of each OR gate in its group to supply a logical 1 output, thereby simulating that the associated device has a later use than any other device. For example, the OR gate 60 is associated with the device B and the use input line 21. Accordingly, the OR gate 60 receives the disable signal on the use input disable line 51a, indicating the disable status of the device B and the signal from the use flip-flop 10 on the reset output line 30b indicating the use history of the device B vis-a-vis the device A. Similarly, each OR gate 61 to 71 receives as inputs the disable signal on that one of the use input disable lines 50a to 53a associated with a device associated with the OR gate group of which the gate is a member, and also the use flip-flop 10 to 15 output associated as explained earlier, with the input connected to the use input line associated with its group. The other OR gate groups in this example comprise gates 61, 64 and 71; 62, 65 and 68; and 63, 66, and 69.

The outputs on respective lines 80 to 91 of OR gates 60 to 71 are supplied to the AND gates 100 to 103 according to the following rule. An AND gate receives as inputs the outputs from a set of OR gates of a set being connected to both (i) a use input disable line 50a to 53a not associated with that AND gate (via the AND gate association with the use input lines 20 to 23) and (ii) to the other of the use flip-flop 10 to 15 outputs associated with inputs receiving the use input signal on the use input lines 20 to 23 with which the AND gate involved is associated. To exemplify this, using the OR gate 60 again as an example, the AND gate 100 receives an input on the line 80 which is the output of the OR gate which receives (i) a disable signal for device B (a use input disable line not associated with the AND gate 100 or the use input line 20) and (ii) the R output of the use flip-flop 10 (the other output of the use flip-flop 10 associated with an input connected to the use input line with which the AND gate 100 is associated, in this case the use input of device A on the use input line 20). In this fashion, the entire network illustrated is constructed to provide LRU resolution with the option of ignoring any one or more of the devices in establishing their use history, accordingly as the disable flip-flops 40 to 43 are set by signals on the lines 110 to 113.

In certain circumstances, it may be useful to provide the option of disabling for only a certain number of the devices. It is possible to modify the network shown by removing that portion of the logic associated with the ignoring of a particular device or devices and still provide the option of ignoring those for which the logic circuitry remains. For example, if it was determined that the device A was an essential or a totally reliable device which would never be ignored no matter what the situation, the drawing can be modified to provide this condition by removing the group of OR gates associated with the device A and its use input signal line 20. Thus the OR gates 63, 66, and 69 are removed and their inputs on set output lines 30a, 31a, 32a are instead respectively connected directly to the lines 83, 86 and 89. The disable flip-flop 40 is also removed along with its lines 50a and 50b. In particular, the AND gate 100 no longer receives the not disabled signal on the line 50b from the disable flip-flop 40. This input to the AND gate 100 can instead be conveniently tied to any of the other three lines 80 to 82, or a three input AND gate may be used for the AND gate 100. That is, where no OR gate group is present to permit any specific one of the devices A to D to be ignored, the input to the particular AND gate 100 to 103 in this case is the other of the outputs of the use flip-flops 10 to 15 associated with an input receiving the use input signal with which the AND gate is associated. In this manner, the illustrated network may be tailored to provide the capability for ignoring any one or more of the devices.

A least recently used resolving network according to the present invention may employ different types of logic gates and flip-flops to that illustrated. It should be noted that selection of logical 0 and logical 1 levels is purely arbitrary. Depending on the family of logic circuits selected, implementations may differ in some respects but be equivalent from a Boolean standpoint.

**Claims**

1. A least recently used resolving network of the type having a plurality of use input lines (20—23), each line having assigned to it one existing device (A—D) whose use history is to be included in the resolution and carrying a use input signal pulse generated responsive to each use of the assigned device, the network comprising a plurality of use flip-flops (10—15) for recording the relative use history of all said devices, each flip-flop being of the type having set and reset inputs (S, R) and set and reset outputs (S, R) producing signals logically inverted with respect to each other and respectively associated with the corresponding inputs, each of said outputs producing a logical 1 signal responsive to a use signal pulse received at its associated input, and the inputs of each use flip-flop being connected to the use input lines assigned to a unique combinatorial pair of devices (AB, AC, AD, BC, BD, CD) at least one use input disable line (50a, 51a, 52a, 53a) which, when carrying a disable signal indicates that an associated use input line (20, 21, 22, 23) and the device (A, B, C, D) assigned thereto are to be ignored in resolving the LRU status of the devices, at least one set of OR gates (60—62, 63—65, 66—68, 69—71), each set being associated with one use input line, and each OR gate in the set being connected to receive at a first input, the other of the outputs of a different use flip-flop (30a—35b) having as one input the use input line (20—23) with which the set of OR gates is associated, and to receive at a second input, the use input disable line (50a—53a) associated with the use input line (20—23) to which is assigned a device (A, B, C, D) other than the device assigned to the use input line associated with the set of OR gates, and a plurality of multiple input AND gates (100—103), each associated with one use input line to indicate its assigned device as the least recently used device when all the inputs to the AND gate are satisfied, and each receiving, in operation, as inputs the outputs of the set of OR gates associated with use input line with which the AND gate is associated, and as an additional input (50b—53b) the logical inversion of the signal on the disable line whose associated input line (20—23) is that associated with the AND gate.

2. A network as claimed in claim 1, characterised in that the network comprises at least one group of OR gates (63, 66, 69; 60, 67, 70; 61, 64, 71; 62, 65, 68), each group associated with one use input line (20; 21; 22; 23), each OR gate in a group being connected at a first input to the output (30a, 31a, 32a; 30b, 33a, 34a; 31b, 33b, 35a; 32b, 34b, 35b) corresponding to the input use line associated with that group of OR gates of a different use flip-flop (10, 11, 12; 10, 13, 14; 11, 13, 15; 12, 14, 15) having an input connected to the use input line (20; 21; 22; 23) associated with that group of OR gates, and at a second input to the use input disable line (50a; 51a; 52a; 53a) associated with the device whose use input line is associated with that group of OR gates, and a plurality of multiple input AND gates (100, 101, 102, 103), each associated with one use input line to indicate its assigned device as the least recently used device when all the inputs to the AND gate are satisfied and receiving, in operation, as inputs the outputs of a set of the OR gates (60, 61, 62; 63, 64, 65; 66, 67, 68; 69, 70, 71) and the logical inversion of the disable signal associated with the device (A, B, C, D) assigned to the AND gate, each OR gate in a set being one of those whose first input is from the other output (30b, 31b, 32b; 30a, 33b, 34b; 31a, 33a, 35b; 32a, 34a, 35a) of a use flip-flop (10, 11, 12; 10, 13, 14; 11, 13, 15; 12, 14, 15) whose one output corresponds with the input from the use input line (20, 21, 22, 23) associated with the device assigned to the AND gate receiving the outputs of that set of OR gates, and whose second input is from a use input disable line (51a, 52a, 53a; 50a, 52a, 53a; 50a, 51a, 53a; 50a, 51a, 52a) associated with a device other than the device assigned to the AND gate.

3. A network as claimed in claim 1 or 2, characterised by including at least one disable flip-flop (40, 41, 42, 43) for supplying a disable signal from its set output, and for receiving at its set input a use input disable signal associated with a device, so that a pulse setting the flip-flop receiving it is indicative that the associated device is to ignored in resolving usage of the devices.

**Patentansprüche**

1. Netzwerk zur Auflösung des Problems der am weitesten zurückliegenden Benutzung, mit einer Vielzahl von Benutzungs-Eingangsleitungen (20—23), denen jeweils ein vorhandenes Gerät (A—D), dessen Benutzungsverlauf in die Auflösung eingeschlossen werden soll, zugeordnet ist und die jeweils einen Nutzung-Einsgangssignalimpuls führen, der bei jeder Benutzung des zugeordneten Gerätes erzeugt wird, wobei das Netzwerk folgende Teile umfaßt:

eine Vielzahl von Benutzungs-Flipflops (10—15) zur Aufzeichnung des relativen Benutzungsverlaufs aller der Geräte, wobei jedes Flipflop Setz-und Rücksetz-Eingänge (S, R) und Setz- und Rücksetz-Ausgänge (S, R) aufweist, die Signale erzeugen, die bezüglich einander logisch invertiert sind und jeweils den entsprechenden Eingängen zugeordnet sind, wobei jeder der Ausgänge ein logisches 1-Signal in Abhängigkeit von einem an dem zugehörigen Eingang empfangenen Benutzungs-Signalimpuls erzeugt und wobei die Eingänge jedes Benutzungs-Flipflops mit den Benutzungs-Eingangsleitungen verbunden sind, die einem eindeutigen Kombinationspaar von Geräten (AB, AC, AD, BC, BD, CD) zugeordnet, sind,

zumindestens eine Benutzungseingang-Abschaltleitung (50a, 51a, 52a, 53a), die, wenn sie ein Abschaltsignal führt, anzeigt, daß eine zugehörige Benutzungs-Eingangsleitung (20, 21, 22, 23) und das dieser zugeordnete Gerät (A, B, C, D) bei der Auflösung des Status der am weitesten zurückliegenden Benutzung zu ignorieren ist, zumindestens ein Satz von ODER-Verknüpfungsgliedern (60—62, 63—65, 66—68, 69—71), wobei jeder Satz einer Benutzungs-Eingangsleitung zugeordnet ist und jedes ODER-Verknüpfungsglied in dem Satz so geschaltet ist, daß es an einem ersten Eingang den anderen der Ausgänge eines anderen Benutzungs-Flipflops (30a—35b) empfängt, das als einen Eingang die Benutzungs-Eingangsleitung (20—23) hat, der der Satz von ODER-Verknüpfungsgliedern zugeordnet ist, und daß es an einem zweiten Eingang die Benutzungseingangs-Abschaltleitung (50a—53a) empfängt, die der Benutzungs-Eingangsleitung (20—23) zugeorndet ist, der ein anderes Gerät (A, B, C, D) zugeordnet ist, als das Gerät, das der Benutzungs-Eingangsleitung zugeordnet ist, die diesem Satz von ODER-Verknüpfungsgliedern zugeordnet ist, und

eine Vielzahl von mehrere Eingänge aufweisenden UND-Verknüpfungsgliedern (100—103), die jeweils einer Benutzungs-Eingangsleitung zugeordnet sind, um das zugehöhrige Gerät als das Gerät mit der am weitesten zurückliegenden Benutzung zu bezeichnen, wenn alle Eingänge an das UND-Verknüpfungsglied wahr sind, und die jeweils im Betrieb als Eingänge die Ausgänge des Satzes von ODER-Verknüpfungsgliedern, der der Benutzungs-Eingangsleitung zugeordnet ist, der das UND-Verknüpfungsglied zugeordnet ist, und jeweils als zusätzlichen Eingang (50b—53b) die logische Umkehrung des Signals an derjenigen Abschaltleitung empfangen, deren zugehörige Eingangsleitung (20—23) diejenige ist, die diesem UND-Verknüpfungsglied zugeordnet ist.

2. Netzwerk nach Anspruch 1, dadurch gekennzeichnet, daß das Netzwerk zumindestens eine Gruppe von ODER-Verknüpfungsgliedern (63, 66, 69; 60, 67, 70; 61, 64, 71; 62, 65, 68) umfaßt, daß jede Gruppe einer Benutzungs-Eingangsleitung (20; 21; 22; 23) zugeordnet ist, daß jedes ODER-Verknüpfungsglied in einer Gruppe an einem Eingang mit dem Ausgang (30a, 31a, 32a; 30b, 33a, 34a; 31b, 33b, 35a; 32b, 34b, 35b) verbunden ist, der der Eingangs-Benutzungsleitung entspricht, die der Gruppe von ODER-Verknüpfungsgliedern eines anderen Benutzungs-Flipflops (10, 11, 12; 10, 13, 14; 11, 13, 15; 12, 14, 15) zugeordnet ist, das einen Eingang aufweist, der mit der Benutzungs-Eingangsleitung (20; 21; 22; 23) verbunden ist, die dieser Gruppe von ODER-Verknüpfungsgliedern zugeordnet ist, daß jedes dieser ODER-Verknüpfungsglieder weiterhin an einem zweiten Eingang mit der Benutzungs-Eingangsabschaltleitung (50a; 51a; 52a; 53a) verbunden ist, die dem Gerät zugeordnet ist, dessen Benutzungs-Eingangsleitung dieser Gruppe von ODER-Verknüpfungsgliedern zugeordnet ist, daß das Netzwerk weiterhin eine Vielzahl von mehrere Eingänge aufweisenden UND-Verknüpfungsgliedern (100, 101, 102, 103) aufweist, die jeweils einer Benutzungs-Eingangleitung zugeordnet sind, um das zugehörige Gerät als dasjenige zu bezeichnen, das die am weitesten zurückliegende Benutzung aufweist, wenn alle Eingänge dieses UND-Verknüpfungsgliedes wahr sind, und die jeweils im Betrieb als Eingänge die Ausgänge eines Satzes von ODER-Verknüpfungsgliedern (60, 61, 62; 63, 64, 65; 66, 67, 68; 69, 70, 71) und die logische Umkehrung des Abschaltsignals empfangen, das dem Gerät (A, B, C, D) zugeordnet ist, das dem UND-Verknüpfungsglied zugeordnet ist, daß jedes ODER-Verknüpfungsglied in einem Satz eines derjenigen ist, dessen erster Eingang von dem anderen Ausgang (30b, 31b, 32b; 30a, 33b, 34b; 31a, 33a, 35b; 32a, 34a, 35a) eines Benutzungs-Flipflops (10, 11, 12; 10, 13, 14; 11, 13, 15; 12, 14, 15) geliefert wird, dessen einer Ausgang dem Eingang von der Benutzungs-Eingangsleitung (20, 21, 22, 23) entspricht, die dem Gerät zugeordnet ist, das dem UND-Verknüpfungsglied zugeordnet ist, das die Ausgänge dieses Satzes von ODER-Verknüpfungsgliedern empfängt, und das dasjenige ist, dessen zweiter Eingang von einer Benutzungs-Eingangsabschaltleitung (51a, 52a, 53a; 50a, 52a, 53a; 50a, 51a, 53a; 50a, 51a, 52a) geliefert wird, die einem anderen Gerät zugeordnet ist, als dem dem UND-Verknüpfungsglied zugeordneten Gerät.

3. Netzwerk nach Anspruch 1 oder 2, dadurch gekennzeichnet, daß es zumindestens ein Abschalt-Flipflop (40, 41, 42, 43) zur Lieferung eines Abschaltsignals von seinem Setz-Ausgang und zum Empfang eines einem Gerät zugeordneten Benutzungs-Eingangsabschaltsignals an seinem Setz-Eingang derart einschließt, daß ein Impuls, der das ihn empfangende Flipflop setzt, anzeigt, daß das zugehörige Gerät bei der Auflösung der Benutzung der Geräte zu ignorieren ist.

### Revendications

1. Circuit de résolution au moins récemment utilisé du type comprenant plusieurs lignes d'entrée d'utilisation (20, 23), à chaque ligne étant affecté un dispositif existant (A—D) dont le histoire d'utilisation doit être incluse dans la résolution et transmettant une impulsion de signal d'entrée d'utilisation produite en réponse à chaque utilisation du dispositif affecté, le circuit comportant plusieurs circuits bistables d'utilisation (10—15) destinées à enregistrer l'histoire d'utilisation relative de tous lesdits dispostifs, chaque circuit bistable étant du type comprenant des entrées de forçage et de mise à zéro (S—R) et des sorties de forçage et de mise à zéro (S—R) produisant des signaux inversés logiquement les uns par rapport aux autres et associées respectivement avec les entrées correspondantes, chacune desdites sorties produisant un signal logique "1" en réponse à une impulsion de signal d'utilisation reçue à son entrée associée et les entrées de chaque circuit bistable d'utilisation étant connectées aux lignes d'entrée d'utilisation affectées à une paire combinatoire unique de dispositifs (AB, AC, AD, BC, BD, CD) à au moins une ligne d'inhibition d'entrée d'utilisation (50a, 51a, 52a, 53a) qui, lorsqu' elle transmet un signal d'inhibition, indique que la ligne d'entrée d'utilisation associée (20, 21, 22, 23) et le dispositif (A, B, C, D) qui lui est affecté doivent être négligés dans la résolution de l'état LRU des dispositifs, au moins un ensemble de portes OU (60—62, 63—65, 66—68, 69—71), chaque ensemble étant associé avec une ligne d'entrée d'utilisation et chaque porte OU de l'ensemble étant connectée pour recevoir, à une première entrée, l'autre des sorties d'un circuit bistable d'utilisation différent (30a, 35a) recevant comme une entrée la ligne d'entrée d'utilisation (20—23) avec laquelle l'ensemble des portes OU est associée, et pour recevoir, à une seconde entrée, la ligne d'inhibition d'entrée d'utilisation (50a, 53a) associée avec la ligne d'entrée d'utilisation (20, 23) à laquelle est affecté un dispositif (A, B, C, D) autre que le dispositif affecté à la ligne d'entrée d'utilisation associée avec l'ensemble des portes OU et plusieurs portes ET à entrées multiples (100, 103) associées chacune avec une ligne d'entrée d'utilisation pour indiquer son dispositif affecté comme le dispositif le moins récemment utilisé quand toutes les entrées de la porte ET sont satisfaites et recevant chacune, en fonctionnement, comme des entrées les sorties de l'ensemble des portes OU associés avec la ligne d'entrée d'utilisation avec laquelle la porte ET est associée et, comme une entrée supplémentaire (50b, 53b) l'inversion logique du signal sur la ligne d'inhibition dont la ligne d'entrée associée (20, 23) est celle associée avec la porte ET.

2. Circuit selon la revendication 1, caractérisé en ce qu'il comporte au moins un groupe de portes OU (63, 66, 69; 60, 67, 70; 61, 64, 71; 62, 65, 68), chaque groupe associée avec une ligne d'utilisation (20; 21; 22, 23), chaque porte OU dans un groupe étant connectée par une première entrée à la sortie (30a, 31a, 32a; 30b, 33a, 34a; 31b, 33b, 35a; 32b, 34b, 35b) correspondant à la ligne d'utilisation d'entrée associée avec ce groupe de portes OU d'un circuit bistable d'utilisation différent (10, 11, 12; 10, 13, 14; 11, 13, 15; 12, 14, 15) comprenant une entrée connectée à la ligne d'entrée d'utilisation (20, 21; 22; 23) associée avec ce groupe de portes OU et, par une seconde entrée, à la ligne d'inhibition d'entrée d'utilisation (50a, 51a, 52a; 53a) associée avec le dispositif dont la ligne d'entrée d'utilisation est associée avec ce groupe de portes OU et plusieurs portes ET à entrées multiples (100, 101, 102, 103) associées chacune avec une ligne d'entrée d'utilisation pour indiquer son dispositif affecté comme le dispositif le moins récemment utilisé quand toutes les entrées de la porte ET sont satisfaites et recevant, en fonctionnement, comme des entrées les sorties d'un ensemble de portes OU (60, 61, 62; 63, 64, 65; 66, 67, 68; 69, 70, 71) et l'inversion logique du signal d'inhibition associée avec le dispositif (A, B, C, D) affecté à la porte ET, chaque porte OU dans un ensemble étant l'une de celles dont la première entrée provient de l'autre sortie (30b, 31b, 32b; 30a, 33b, 34b; 31a, 33a, 33b; 32a, 34a, 35a) d'un circuit bistable d'utilisation (10, 11, 12; 10, 13, 14; 11, 13, 15; 12, 14, 15) dont une sortie correspond à l'entrée provenant de la ligne d'entrée d'utilisation (20, 21, 22, 23) associée avec le dispositif affecté à la porte ET recevant les sorties de cet ensemble de portes OU et dont une seconde entrée provient d'une ligne d'inhibition d'entrée (51a, 52a, 53a; 50a, 52a, 53a; 50a, 51a, 53a; 50a, 51a, 52a) associées avec un dispositif autre que le dispositif affecté à la porte ET.

3. Circuit selon la revendication 1 ou 2, caractérisé en ce qu'il comporte au moins un circuit bistable d'inhibition (40, 41, 42, 43) destiné à fournir un signal d'inhibition par sa sortie de forçage et à recevoir à son entrée de forçage un signal d'inhibition d'entrée d'utilisation associé avec un dispositif de manière qu'une impulsion positionnant le circuit bistable qui la reçoit indique que le dispositif associé doit être ignoré dans l'usage de résolution des dispositifs.

0 050 919